# EUROPÄISCHE PATENTSCHRIFT

(11) **EP 1 031 860 B1**
(45) Veröffentlichungstag und Bekanntmachung des Hinweises auf die Patenterteilung: **27.10.2004**
(21) Anmeldenummer: 00102995.8
(22) Anmeldetag: 14.02.2000
(51) Int. Cl.: G02B 6/42

(54) **Verfahren und Gie form zur Herstellung eines elektrooptischen Moduls und elektrooptisches Modul**
Method and mold for fabrication of an electro-optical modul and electro-optical modul
Méthode et moule pour la fabrication d'un module électro-optique et module électro-optique

(30) Priorität: 22.02.1999 DE 19909242
(43) Veröffentlichungstag der Anmeldung: 30.08.2000
(73) Patentinhaber: Infineon Technologies AG, 81669 München (DE)
(72) Erfinder: Müller, Gustav Dr., 93059 Regensburg (DE); Hurt, Hans, 93049 Regensburg (DE)
(74) Vertreter: Maikowski, Michael, Dipl.-Ing. Dr.

(56) Entgegenhaltungen:
- EP-A- 0 450 560
- WO-A-98/06141
- DE-A- 19 711 138
- GB-A- 2 162 335
- US-A- 5 763 900
- PATENT ABSTRACTS OF JAPAN vol. 2000, no. 07, 29. September 2000 (2000-09-29) -& JP 2000 110176 A (FUJITSU LTD), 18. April 2000 (2000-04-18) -& US 6 170 996 B1 (MIURA ET AL) 9. Januar 2001 (2001-01-09)

## Beschreibung

Die Erfindung bezieht sich auf ein Verfahren zum Herstellen eines elektrooptischen Moduls mit einem Formkörper aus einem lichtdurchlässigen, formbaren Material, bei dem ein Träger mit einer Positioniereinrichtung und mit mindestens einem ausgerichtet aufgebrachten elektrooptischen wandler mittels der Positioniereinrichtung exakt in einer Gießform positioniert wird und der Träger mit dem Wandler zumindest teilweise mit dem formbaren Material unter Bildung des Formkörpers umgeben wird, wobei der Formkörper mindestens eine der Kopplung mit einem Kopplungspartner dienende Funktionsfläche erhält.

Ein Verfahren dieser Art ist aus der deutschen Offenlegungsschrift DE 197 11 138 A1 bekannt. Bei diesem bekannten Verfahren wird ein elektrooptischer Wandler in einer vorbestimmten Position auf einem Träger angeordnet, der mit mindestens einem Positionierelement als Positioniereinrichtung versehen wird. Der Träger wird mittels des Positionsierelementes exakt in einer Bestückungseinrichtung positioniert. Nachfolgend wird der Träger mittels des Positionsierelementes exakt in einer Gußform positioniert und unter Ausbildung eines Formkörpers und einer Funktionsfläche mit formbarem Material umgeben; die Funktionsfläche, z. B. eine Linse, dient dabei zur Kopplung mit einem Kopplungspartner.

Der Erfindung liegt die Aufgabe zugrunde, ein Verfahren zum Herstellen eines elektrooptischen Moduls anzugeben, bei dem in fertigungstechnisch vergleichsweise einfacher Weise eine präzise Anordnung und Ausbildung der Funktionsfläche an dem elektrooptischen Modul erreichbar ist.

Zur Lösung dieser Aufgabe wird bei einem Verfahren der eingangs angegebenen Art erfindungsgemäß das sich im Ankopplungsbereich befindende Gehäuseteil nach Bildung des Formkörpers in dem Modulgehäuse von dem Modulgehäuse entfernt.

Ein wesentlicher Vorteil des erfindungsgemäßen Verfahrens besteht darin, daß mit ihm die Funktionsfläche in fertigungstechnisch vergleichsweise einfacher Weise hochpräzis positioniert am elektrooptischen Modul angebracht werden kann. Dies ist im wesentlichen darauf zurückzuführen, daß ein vorgefertigtes Modulgehäuse verwendet wird, in das das lichtdurchlässige, formbare Material nach Einbringung des Trägers gegossen wird; durch Schrumpfprozesse beim Aushärten des formbaren Materials können sich wegen der Verwendung eines vorgefertigten Modulgehäuses Justierungenauigkeiten nicht einstellen. Ein weiterer Vorteil des erfindungsgemäßen Verfahrens besteht darin, daß das vorgefertigte Modulgehäuse auch in Spritzgußtechnik hergestellt sein kann und deshalb auch mit Hinterschneidungen versehen werden kann. Ein zusätzlicher Vorteil wird darin gesehen, daß wegen der Verwendung eines vorgefertigten Modulgehäuses vorzugsweise in Spritzgußtechnik aufgrund der Verwendung eines im ausgehärteten Zustand mechanisch besonders festen Werkstoff eine relativ hohe mechanische Festigkeit des hergestellten elektrooptischen Moduls erreichbar ist.

Um ein einsatzfähiges elektrooptisches Modul zu gewinnen, ist es erforderlich, das elektrooptische Modul von dem Gehäuseteil zu befreien, das sich im Ankopplungsbereich befindet. Dies kann in unterschiedlicher Weise vorgenommen werden. Um diesen Schritt zu erleichtern, wird es als besonders vorteilhaft angesehen, wenn ein an seinem Rand eine Sollbruchstelle aufweisendes Gehäuseteil verwendet wird. Aufgrund der Sollbruchstelle läßt sich dann das Gehäuseteil leicht herausbrechen.

Es wird ferner als vorteilhaft angesehen, wenn als Gießform ein Modulgehäuse mit einem Ankopplungsbereich verwendet wird, der als ein eine Steckbucht zur Aufnahme des Kopplungspartners bildender Stutzen gestaltet ist. Der Vorteil dieser Ausgestaltung des erfindungsgemäßen Verfahrens besteht vor allem darin, daß das Vergießen mit dem formbaren Material erleichtert wird, weil dieses den Stutzen nicht selbst bildet, sondern dieser bereits an dem Modulgehäuse vorgesehen ist.

Bei der eben angegebenen Ausführungsform des erfindungsgemäßen Verfahrens wird das an seiner äußeren Seite mit einem Abbruchfortsatz versehene Gehäuseteil nach der Bildung des Formkörpers durch Krafteinwirkung auf den Abbruchfortsatz aus dem Modulgehäuse entfernt. Es wird dadurch die Möglichkeit geschaffen, trotz des im Inneren des Stutzens verborgenen Gehäuseteils dieses leicht entfernen zu können, um die Funktionsfläche freizulegen.

Die Positioniereinrichtung kann bei dem erfindungsgemäßen Verfahren unterschiedlich ausgestaltet werden, als besonders vorteilhaft wird es angesehen, wenn als Positioniereinrichtung Ansätze an dem Träger dienen, die beim Positionieren des Trägers mit dem Wandler in dem Modulgehäuse mit dem Modulgehäuse verrastet werden.

Die Erfindung betrifft ferner eine Gießform zum Herstellen eines optisches Moduls mit einem Formkörper aus einem lichtdurchlässigen, formbaren Material, bei dem ein Träger mit einer Positioniereinrichtung und mit mindestens einem ausgerichtet aufgebrachten elektrooptischen Wandler mittels der Positioniereinrichtung exakt in der Gießform positioniert wird und der Träger mit dem Wandler zumindest teilweise mit dem formbaren Material unter Bildung des Formkörpers umgeben wird, wobei der Formkörper mindestens eine der Kopplung mit einem Kopplungspartner dienende Funktionsfläche erhält.

Die Gießform ist als Modulgehäuse mit einer Öffnung zum Einführen des Trägers und mit einem Ankopplungsbereich für den Kopplungspartner ausgebildet. Im Ankopplungsbereich befindet sich ein Gehäuseteil, das an seiner inneren Seite der Außenkontur der Funktionsfläche entsprechend gestaltet ist. Eine solche Gießform ist ebenfalls in der DE 197 11 138 A1 beschrieben.

Um die Justiergenauigkeit und die mechanische Festigkeit eines herzustellenden elektrooptischen Moduls mit einem Formkörper aus einem lichtdurchlässigen, formbaren Material zu erhöhen, ist erfindungsgemäß das im Ankopplungsbereich angeordnete Gehäuseteil nicht einstückig mit dem Modulgehäuse ausgebildet und von diesem entfernbar. Nach Einfüllen des formbaren Materials in das Modulgehäuse und Bildung des Formkörpers kann das Gehäuseteil somit aus dem Ankopplungsbereich entfernt werden.

Die Gießform stellt zwar im Vergleich zu der bekannten Gießform eine verlorene Form dar, jedoch bietet sie den Vorteil, dass durch ihre Verwendung die Justiergenauigkeit der Funktionsfläche an dem elektrooptischen Modul verbessert und auch die mechanische Festigkeit des Moduls erhöht wird.

Die Gießform weist vorteilhafterweise hinsichtlich ihres Gehäuseteils an dessen Rand eine Sollbruchstelle auf, um das Gehäuseteil unter Freilegung der Funktionsfläche des elektrooptischen Moduls leicht entfernen zu können.

Ferner ist bei der erfindungsgemäßen Gießform in vorteilhafterweise der Ankopplungsbereich als ein eine Steckbucht zur Aufnahme des Kopplungspartners bildender Stutzen ausgebildet.

Als vorteilhaft wird es ferner angesehen, wenn das Gehäuseteil an seiner äußeren Seite einen Abbruchfortsatz trägt.

Die Erfindung bezieht sich auch auf ein elektrooptisches Modul mit einem Formkörper aus einem lichtdurchlässigen, formbaren Material, bei dem der Träger mit einem elektrooptischen Wandler zumindest teilweise mit dem formbaren Material unter Bildung des Formkörpers umgeben ist, wobei der Formkörper mindestens eine der Kopplung mit einem Kopplungspartner dienende Funktionsfläche erhält.

Ein derartiges elektrooptisches Modul ist ebenfalls der oben behandelten deutschen Offenlegungsschrift 197 11 138 A1 hinsichtlich seines Aufbaus entnehmbar.

Um ein elektrooptisches Modul mit sehr genau justierter Funktionsfläche auf einfache Weise zu gewinnen, weist erfindungsgemäß das Modul ein Modulgehäuse mit einer Öffnung zum Einführen des Trägers und mit einem Ankopplungsbereich für den Kopplungspartner auf, und das Modulgehäuse ist mit dem formbaren Material gefüllt; im Ankopplungsbereich befindet sich eine Funktionsfläche, die beim Füllen des Modulgehäuses mit dem formbaren Material durch ein an seiner inneren Seite der Außenkontur der Funktionsfläche entsprechend gestaltetes und danach entferntes Gehäuseteil gebildet ist.

Vorteilhafterweise weist das Modulgehäuse einen Ankopplungsbereich auf, der als ein eine Steckbucht zur Aufnahme des Kopplungspartners bildender Stutzen ausgebildet ist.

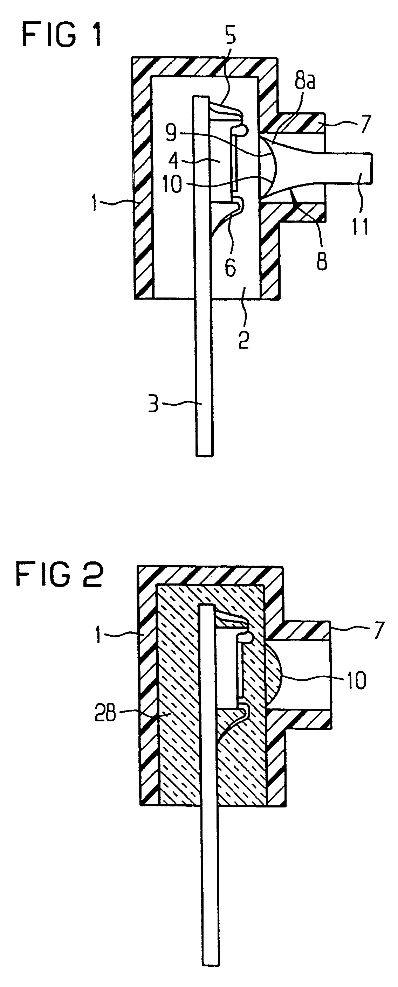

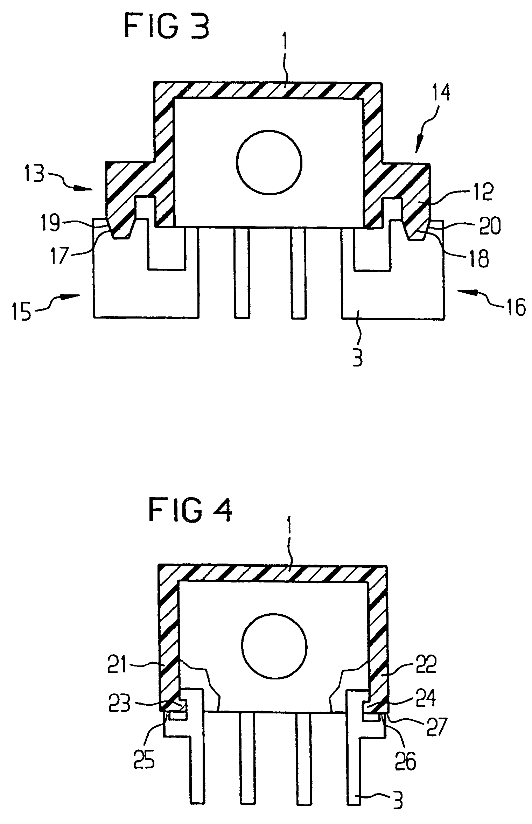

Zur weiteren Erläuterung der Erfindung ist in Figur 1 im Schnitt ein bei dem erfindungsgemäßen Verfahren verwendetes Modulgehäuse mit eingebrachtem Träger, in Figur 2 das fertiggestellte elektrooptische Modul in einer mit der Figur 1 übereinstimmenden Schnittdarstellung, in Figur 3 eine Seitenansicht auf das fertiggestellte elektrooptische Modul mit einer ersten Positioniereinrichtung und in Figur 4 eine Seitenansicht eines weiteren fertiggestellten elektrooptischen Moduls mit einer zweiten Positioniereinrichtung gezeigt.

Wie die Figur 1 zeigt, wird bei der Durchführung des erfindungsgemäßen Verfahrens ein vorgefertigtes Modulgehäuse 1 verwendet, das topfartig ausgebildet ist und an seiner in der Figur 1 unteren Seite mit einer relativ großen Öffnung 2 zum Einbringen eines Trägers 3 versehen ist. Auf diesem Träger 3, bei dem es sich beispielsweise um einen sogenannten Lead Frame handeln kann, ist ein elektrooptischer Wandler 4 exakt positioniert in einem vorangegangenen Verfahrensschritt aufgebracht und über elektrische Leiter 5 und 6 elektrisch mit dem Träger 3 verbunden.

Die Figur 1 zeigt ferner, daß das Modulgehäuse 1 außerdem mit einem Stutzen 7 versehen ist, der eine Steckbucht zur Aufnahme eines nicht dargestellten Kopplungspartners des herzustellenden elektrooptischen Moduls darstellt. Innen am Stutzen 7 im Ankopplungsbereich für den Kopplungspartner befindet sich ein Gehäuseteil 8, das an seiner dem Träger 3 zugewandten Seite 9 eine Außenkontur aufweist, die einerin diesem Bereich zu bildenden Funktionsfläche 10, z. B. einer Linse, des elektrooptischen Moduls entspricht. Das Gehäuseteil 8 ist an seinem Rande als Sollbruchstelle 8a ausgebildet und weist einen Abbruchfortsatz 11 auf, der aus dem Stutzen 7 nach außen hervorsteht.

Die Figuren 3 und 4 zeigen, wie der Träger 3 mit dem elektrooptischen Wandler 4 genau positioniert in dem Modulgehäuse 1 in einer Lage untergebracht werden kann, wie es die Figur 1 erkennen läßt.

Bei dem Ausführungsbeispiel nach Figur 3 ist zur genauen Positionierung des Trägers 3 mit dem elektrooptischen Wandler im Modulgehäuse 1 eine Positioniereinrichtung 12 vorgesehen, die außen am Modulgehäuse 1 angebrachte Positionieransätze 13 und 14 aufweist; mit diesen Positionieransätzen 13 und 14 wirken Positionierhaken 15 und 16 zusammen, die am Träger 3 vorgesehen sind. Zur Positionierung des Trägers 3 mit dem elektrooptischen Wandler wird dieser in das Modulgehäuse 1 eingeschoben, wobei die Positionierhaken 15 und 16 mit keilförmigen Ausnehmungen 17 und 18 gegen entsprechend keilförmig ausgebildete Enden 19 und 20 der Justieransätze des Modulgehäuses 1 geführt und zusammengefügt werden.

Bei der Ausführungsform nach Figur 4 wird eine andere Positioniereinrichtung verwendet. Diese enthält Rastausnehmungen 21 und 22 an der Innenseite des Modulgehäuses 1; in die Rastausnehmungen 21 und 22 greifen Einrastnasen 23 und 24 ein, die vom Träger 3 gebildet sind. Ebenfalls am Träger 3 gebildete Anschlagelemente 25 und 26 sorgen für eine genaue Positionierung und Halterung des Trägers 3 im Modulgehäuse 1, weil sie gegen die Stirnseite 27 des Modulgehäuses 1 geführt werden, wodurch eine Verrastung des Trägers 3 in dem Modulgehäuse 1 eintritt.

In der Figur 2 ist das fertiggestellte elektrooptische Modul in derselben Schnittdarstellung wie in Figur 1 gezeigt. Innen ist das Modulgehäuse 1 nunmehr mit einem lichtdurchlässigen, formbaren Material 28 gefüllt, das nach dem Einbringen zu einem Formkörper ausgehärtet ist. Damit ist auch die Funktionsfläche 10 in Form einer Linse ausgebildet. Nach dem Aushärten des formbaren Materials ist durch einen Druck auf den Abbruchfortsatz 11 das Gehäuseteil 8 aus dem Stutzen 7 entfernt, wodurch die Funktionsfläche 10 freigelegt ist.

## Patentansprüche

1. Verfahren zum Herstellen eines elektrooptischen Moduls mit einem Formkörper aus einem lichtdurchlässigen, formbaren Material, bei dem
- ein Träger (3) mit einer Positioniereinrichtung und mit mindestens einem ausgerichtet aufgebrachten elektrooptischen Wandler (4) mittels der Positioniereinrichtung exakt in einer Gießform positioniert wird,
- der Träger (3) mit dem Wandler (4) zumindest teilweise mit dem formbaren Material unter Bildung des Formkörpers umgeben wird, wobei der Formkörper mindestens eine der Kopplung mit einem Kopplungspartner dienende Funktionsfläche erhält,
- als Gießform ein Modulgehäuse (1) mit einer Öffnung (2) zum Einführen des Trägers (3) und mit einem Ankopplungsbereich für den Kopplungspartner verwendet wird, wobei sich im Ankopplungsbereich ein Gehäuseteil (8) befindet, das an seiner inneren Seite (9) der Außenkontur der Funktionsfläche (10) entsprechend gestaltet ist, und
- der Formkörper durch Einfüllen des formbaren Materials (28) in das Modulgehäuse (1) gebildet wird,
**dadurch gekennzeichnet, dass**
das Gehäuseteil (8) nach Bildung des Formkörpers in dem Modulgehäuse (1) von dem Modulgehäuse (1) entfernt wird.

2. Verfahren nach Anspruch 1,
**dadurch gekennzeichnet, daß**
- das ein an seinem Rand eine Sollbruchstelle (8a) aufweisendes Gehäuseteil (8) verwendet wird.

3. Verfahren nach Anspruch 1 oder 2,
**dadurch gekennzeichnet, daß**
- als Gießform ein Modulgehäuse (1) mit einem Ankopplungsbereich verwendet wird, der als ein eine Steckbucht zur Aufnahme des Kopplungspartners bildender Stutzen (7) gestaltet ist.

4. Verfahren nach einem der vorangehenden Ansprüche,
**dadurch gekennzeichnet , daß**
- das an seiner äußeren Seite mit einem Abbruchfortsatz (11) versehene Gehäuseteil (8) nach der Bildung des Formkörpers (28) durch Krafteinwirkung auf den Abbruchfortsatz (11) aus dem Modulgehäuse (1) entfernt wird.

5. Verfahren nach einem der vorangehenden Ansprüche,
**dadurch gekennzeichnet, daß**
- als Positioniereinrichtung Ansätze (15, 16, 23, 24) an dem Träger (3) dienen, die beim Positionieren des Trägers (3) mit dem Wandler in dem Modulgehäuse (1) mit dem Modulgehäuse verbunden werden.

6. Gießform zum Herstellen eines optischen Moduls mit einem Formkörper aus einem lichtdurchlässigen, formbaren Material, bei dem
- ein Träger (3) mit einer Positioniereinrichtung und mit mindestens einem ausgerichtet aufgebrachten elektrooptischen Wandler (4) mittels der Positioniereinrichtung exakt in der Gießform positioniert wird,
- der Träger (3) mit dem Wandler (4) zumindest teilweise mit dem formbaren Material unter Bildung des Formkörpers umgeben wird, wobei der Formkörper mindestens eine der Kopplung mit einem Kopplungspartner dienende Funktionsfläche erhält,
- die Gießform ein Modulgehäuse (1) mit einer Öffnung (2) zum Einführen des Trägers (3) und mit einem Ankopplungsbereich für den Kopplungspartner ist und
- sich im Ankopplungsbereich ein Gehäuseteil (8) befindet, das an seiner inneren Seite (9) der Außenkontur der Funktionsfläche (10) entsprechend gestaltet ist,
**dadurch gekennzeichnet, dass**
das Gehäuseteil (8) nicht einstückig mit dem Modulgehäuse (1) ausgebildet und von dem Modulgehäuse (1) entfernbar ist.

7. Gießform nach Anspruch 6,
**dadurch gekennzeichnet , daß**
- das Gehäuseteil (8) an seinem Rand eine Sollbruchstelle (8a) aufweist.

8. Gießform nach Anspruch 6 oder 7,
**dadurch gekennzeichnet, daß**
- der Ankopplungsbereich als ein eine Steckbucht zur Aufnahme des Kopplungspartners bildender Stutzen (7) ausgebildet ist.

9. Gießform nach einem der Ansprüche 6 bis 8,
**dadurch gekennzeichnet, daß**
- das Gehäuseteil (8) an seiner äußeren Seite einen Abbruchfortsatz (11) trägt.

10. Elektrooptisches Modul mit einem Formkörper aus einem lichtdurchlässigen, formbaren Material, bei dem der Träger (3) mit einem elektrooptischen Wandler (4) zumindest teilweise mit dem formbaren Material unter Bildung des Formkörpers umgeben ist, wobei der Formkörper mindestens eine der Kopplung mit einem Kopplungspartner dienende Funktionsfläche erhält,
**dadurch gekennzeichnet , dass**
- das Modul ein Modulgehäuse (1) mit einer Öffnung (2) zum Einführen des Trägers (3) und mit einem Ankopplungsbereich für den Kopplungspartner aufweist,
- das Modulgehäuse (1) mit dem formbaren Material (28) gefüllt ist, und
- die Funktionsfläche (10) sich im Ankopplungsbereich des Modulgehäuses befindet.

11. Modul nach Anspruch 10,
**dadurch gekennzeichnet, daß**
- das Modulgehäuse (1) einen Ankopplungsbereich aufweist, der als ein eine Steckbucht zur Aufnahme des Kopplungspartners bildender Stutzen (7) ausgebildet ist.

## Claims

1. Method of producing an electrooptical module having a moulding made of a translucent, mouldable material, in the case of which
- a support (3) with a positioning device and with at least one electrooptical transducer (4) fitted on it in an aligned manner is positioned precisely in a mould by means of this positioning device,
- the support (3) with the transducer (4) is at least partially encased by the mouldable material, the moulding being formed in the process, it being the case that the moulding obtains at least one functional surface serving for coupling to a coupling partner,
- use is made, as the mould, of a module housing (1) with an opening (2) for the introduction of the support (3) and with a coupling region for the coupling partner, it being the case that located in the coupling region is a housing part (8) which, on its inner side (9), is configured in accordance with the outer contour of the functional surface (10), and
- the moulding is formed by the mouldable material (28) being introduced into the module housing (1),
**characterized in that** the housing part (8) is removed from the module housing (1) once the moulding has been formed in the module housing (1).

2. Method according to Claim 1, **characterized in that**
- use is made of a housing part (8) which has a predetermined breaking point (8a) on its border.

3. Method according to Claim 1 or 2, **characterized in that**
- use is made, as the mould, of a module housing (1) with a coupling region which is configured as a stub (7) which forms an insertion socket for receiving the coupling partner.

4. Method according to one of the preceding claims, **characterized in that**
- once the moulding (28) has been formed, the housing part (8), which is provided with a break-off attachment (11) on its outer side, is removed from the module housing (1) by the break-off attachment (11) being subjected to the action of force.

5. Method according to one of the preceding claims, **characterized in that**
- extensions (15, 16, 23, 24) on the support (3) serve as the positioning device and are connected to the module housing (1) when the support (3) with the transducer is positioned in said module housing.

6. Mould for producing an optical module having a moulding made of a translucent, mouldable material, in the case of which
- a carrier (3) with a positioning device and with at least one electrooptical transducer (4) fitted on it in an aligned manner is positioned precisely in the mould by means of the positioning device,
- the support (3) with the transducer (4) is at least partially encased by the mouldable material, the moulding being formed in the process, it being the case that the moulding obtains at least one functional surface which serves for coupling to a coupling partner,
- the mould is a module housing (1) with an opening (2) for the introduction of the support (3) and with a coupling region for the coupling partner, and
- located in the coupling region is a housing part (8) which, on its inner side (9), is configured in accordance with the outer contour of the functional surface (10),
**characterized in that** the housing part (8) is not formed integrally with the module housing (1) and can be removed from the module housing (1).

7. Mould according to Claim 6, **characterized in that**
- the housing part (8) has a predetermined breaking point (8a) on its border.

8. Mould according to Claim 6 or 7, **characterized in that**
- the coupling region is configured as a stub (7) which forms an insertion socket for receiving the coupling partner.

9. Mould according to one of Claims 6 to 8, **characterized in that**
- the housing part (8) bears a break-off attachment (11) on its outer side.

10. Electrooptical module having a moulding made of a translucent, mouldable material, in the case of which a support (3) with an electrooptical transducer (4) is at least partially encased by the mouldable material, the moulding being formed in the process, it being the case that the moulding obtains at least one functional surface serving for coupling to a coupling partner, **characterized in that**
- the module has a module housing (1) with an opening for the introduction of the support (3) and with a coupling region for the coupling partner,
- the module housing (1) is filled with the mouldable material (28), and
- the functional surface (10) is located in the coupling region of the module housing.

11. Module according to Claim 10, **characterized in that**
- the module housing (1) has a coupling region which is designed as a stub (7) which forms an insertion socket for receiving the coupling partner.

## Revendications

1. Procédé de fabrication d'un module électro-optique comprenant une pièce moulée en un matériau transparent et mouiable, dans lequel
- un support (3), ayant un dispositif de mise en position et au moins un transducteur (4) électro-optique appliqué de manière dirigée, est mis en position exactement dans un moule de coulée au moyen du dispositif de mise en position,
- le support (3) avec le transducteur (4) est entouré, au moins en partie, du matériau moulable avec formation de la pièce moulée, la pièce moulée recevant au moins une surface de fonction servant au couplage à un partenaire de couplage,
- il est utilisé, comme moule de coulée, un boîtier (1) de module ayant une ouverture (2) d'introduction du support (3) et une zone de couplage pour le partenaire de couplage, une partie (8) du boîtier, dont la face (9) inférieure est conformée de manière à correspondre au contour extérieur de la surface (10) de fonction, se trouvant dans la zone de couplage, et
- la pièce moulée est formée en emplissant le boîtier (1) de module du matériau (28) moulable,
**caractérisé en ce que**
la partie (8) du boîtier est enlevée du boîtier (1) de module, après formation de la pièce moulée dans le boîtier (1) de module.

2. Procédé suivant la revendication 1,
**caractérisé en ce que**
- il est utilisé une partie (8) de boîtier, ayant sur son bord un point (8a) destiné à se rompre.

3. Procédé suivant la revendication 1 ou 2,
**caractérisé en ce que**
- il est utilisé, comme moule de coulée, un boîtier (1) de module, ayant une zone de couplage, qui est conformée sous la forme d'une tubulure (7) formant une baie d'enfichage pour la réception du partenaire de couplage.

4. Procédé suivant l'une des revendications précédentes,
**caractérisé en ce que**
- la partie (8) de boîtier, munie sur sa face extérieure d'un prolongement (11) à casser, est enlevée du boîtier (1) du module après la formation de la pièce (28) moulée, en appliquant une force sur le prolongement (11) à casser.

5. Procédé suivant l'une des revendications précédentes,
**caractérisé en ce que**
- on se sert comme dispositif de mise en position de saillies (15, 16, 23, 24) sur le support (3), qui, lors de la mise en position du support (3) avec le transducteur dans le boîtier (1) du module, sont reliées au boîtier du module.

6. Moule de coulée pour la fabrication d'un module optique, comprenant une pièce moulée en un matériau transparent et moulable, dans lequel
- un support (3), ayant un dispositif de mise en position et au moins un transducteur (4) électro-optique appliqué de manière dirigée, est mis en position exactement dans un moule de coulée au moyen du dispositif de mise en position,
- le support (3) avec le transducteur (4) est entouré, au moins en partie, du matériau moulable avec formation de la pièce moulée, la pièce moulée recevant au moins une surface de fonction servant au couplage à un partenaire de couplage,
- il est utilisé, comme moule de coulée, un boîtier (1) de module ayant une ouverture (2) d'introduction du support (3) et une zone de couplage pour le partenaire de couplage, une partie (8) du boîtier, dont la face (9) inférieure est conformée de manière à correspondre au contour extérieur de la surface (10) de fonction, se trouvant dans la zone de couplage, et
**caractérisé en ce que**
- la partie (8) du boîtier n'est pas d'un seul tenant avec le boîtier (1 ) du module et peut être enlevée du boîtier (1) du module.

7. Moule de coulée pour la fabrication d'un module optique suivant la revendication 6,
**caractérisé en ce que**
- la partie (8) du boîtier a, sur son bord, un point (8a) déstiné à se rompre.

8. Moule de coulée pour la fabrication d'un module optique suivant la revendication 6 ou 7,
**caractérisé en ce que**
- la zone de couplage est constituée sous la forme d'une baie d'enfichage pour la réception du partenaire de couplage.

9. Moule de coulée pour la fabrication d'un module optique suivant l'une des revendications 6 à 8,
**caractérisé en ce que**
- la partie (8) du boîtier porte sur sa face extérieure un prolongement (11 ) à casser.

10. Module électro-optique comprenant une pièce moulée en un matériau transparent et moulable, dans lequel le support (3) ayant un transducteur (4) électro-optique est entouré, au moins en partie, du matériau moulable avec formation de la pièce moulée, la pièce moulée recevant au moins une surface de fonction servant au couplage avec un partenaire de couplage,
**caractérisé en ce que**
- le module comporte un boîtier (1) de module ayant une ouverture (2) d'introduction du support (3) et une zone de couplage du partenaire de couplage,
- le boîtier (1) du module est empli du matériau (28) moulable, et
- la surface (10) de fonction se trouve dans la zone de couplage du boîtier du module.

11. Module suivant la revendication 10,
**caractérisé en ce que**
- le boîtier (1) du module a une zone de couplage, qui est constituée sous la forme d'une tubulure (7) formant une baie d'enfichage de réception du partenaire de couplage.
